# EUROPÄISCHE PATENTANMELDUNG

(11) **EP 2 315 245 A1**
(43) Veröffentlichungstag der Anmeldung: **27.04.2011**
(21) Anmeldenummer: 10170735.4
(22) Anmeldetag: 26.07.2010
(51) Int. Cl.: H01L 25/07, H01L 23/495

(54) **Leistungshalbleitermodul mit einem eine dreidimensionale Oberflächenkontur aufweisendenSubstrat sowie Herstellungsverfahren hierzu**

(30) Priorität: 21.10.2009 DE 102009050178
(71) Anmelder: SEMIKRON Elektronik GmbH & Co. KG, 90431 Nürnberg (DE)
(72) Erfinder: Dr. Stockmeier, Thomas, 91054, Erlangen (DE)

(57) **Zusammenfassung**

Die Erfindung beschreibt ein Leistungshalbleitermodul und ein Herstellungsverfahren hierzu, beginnend mit einem Grundsubstrats mit einer isolierenden Lage und einer in sich strukturierten und somit erste Teillagen ausbildenden ersten Metalllage. Eine zweite Metalllage wird anschließend derart ausgebildet, dass einzelne Teillagen mit einer dreidimensionalen Oberflächenstruktur ausgebildet werden. Nach der Anordnung, vorzugsweise mittels eines Drucksinterverfahrens, dieser zweiten Teillagen auf zugeordneten ersten Teillagen werden noch Leistungshalbleiterbauelemente auf den zweiten Metalllagen angeordnet. Es können aus diesen zweiten Teillagen auch die Lastanschlusselemente zur externen Kontaktierung des Leistungshalbleitermoduls ausgebildet werden.

## Beschreibung

Die Erfindung beschreibt ein Leistungshalbleitermodul und ein Herstellungsverfahren hierzu mit einer speziellen Ausgestaltung des die Leistungshalbleiterbauelemente tragenden Substrats.

Beispielhaft ist in der DE 103 55 925 A1 ein Leistungshalbleitermodul offenbart, mit einem flächigen Substrat hierauf schaltungsgerecht angeordneten Leiterbahnen, die als Teillagen einer flächigen Metalllage ausgebildet sind, analog den bekannten und vielfach in Leistungshalbleitermodulen verwendeten DCB- Substraten. Auf den Leiterbahnen sind Leistungshalbleiterbauelemente und elektrisch leitfähige Distanzelementen mit den Leistungshalbleiterbauelementen vergleichbaren Dimensionen, angeordnete. Diese Elemente sind mittels einer Verbindungseinrichtung verbunden, die aus einem Folienverbund aus mindestens zwei metallischen Folienschichten mit jeweils einer dazwischen angeordneten elektrisch isolierenden Folienschicht besteht.

Aus der DE 10 2007 054 710 A1 ist es bekannt eine dieser oben genannten grundsätzlich gleichartigen Verbindungseinrichtung unter Umgehung der Distanzelemente derart in einem Leistungshalbleitermodul anzuordnen, dass die Höhenunterschiede zwischen den Leistungshalbleitermodulen und dem Substrat durch Verformen der Verbindungseinrichtung selbst ausgeglichen werden.

Nachteilig am genannten Stand der Technik ist somit, dass zum Ausgleich der unterschiedlichen Niveaus zwischen dem Substrat und den Leistungshalbleiterbauelementen entweder zusätzlich Distanzelemente vorzusehen sind oder die Verbindungseinrichtung zu verformen ist. Ersteres erfordert einen zusätzlichen Arbeitschritt zur Anordnung, während letzteres bei komplexeren zu verbindenden Strukturen Spannungen in der Verbindungseinrichtung erzeugen kann. Darüber hinaus können mit der bekannten Verbindungseinrichtung nur Lastanschlusselemente zur externen Verbindung des Leistungshalbleitermoduls für kleine bis mittlere Leistungen zufriedenstellend ausgebildet werden.

Weiterhin ist beispielhaft aus der aus der DE 10 2006 058 695 A1 oder der DE 10 2006 006 425 A1 bekannt Lastanschlusselemente eines Leistungshalbleitermoduls als Metallformkörper auszubilden, die mit Leiterbahnen des Substrats stoff- oder kraftschlüssig verbunden sind.

Der Erfindung liegt somit die Aufgabe zugrunde, ein Leistungshalbleitermodul mit einem weitergebildeten Substrat und ein Herstellungsverfahren hierfür anzugeben, das einer einfach Anordnung interner elektrischer Verbindungseinrichtungen ebenso zugänglich ist wie einer erweiterten Funktionalität dieses Substrats selbst beispielhaft als Verbindungs- oder Anschlusseinrichtung.

Diese Aufgabe wird erfindungsgemäß gelöst, durch ein Leistungshalbleitermodul mit den Merkmalen des Anspruchs 1 und durch ein Herstellungsverfahren mit den Merkmalen des Anspruchs 5. Bevorzugte Ausführungsformen sind in den jeweils abhängigen Ansprüchen beschrieben.

Den grundlegenden Ausgangspunkt der Erfindung bildet ein Leistungshalbleitermodul der oben genannten Art. Dieses weist ein Substrat mit einer elektrisch isolierenden Lage und mit einer ersten Metalllage auf, die in sich strukturiert ist und somit Teillagen ausbildet. Derartige Substrate sind beispielhaft als DCB- (direct copper bonded) Substrat vielfach in Bereich der Leistungshalbleitermodule in Verwendung. Diese zeichnen sich durch einen Isolierstoffkörper mit meist beidseitiger Kupferkaschierung aus, die zwei plane Hauptflächen ausbildet, wobei auf der ersten Hauptfläche und dort auf der strukturierten Kupferkaschierung Bauelemente, wie beispielhaft Leistungshalbleiterschalter, Widerstände und Sensoren, angeordnet sind, während die zweite in sich meist nicht strukturierte Kupferkaschierung mit einer Kühleinrichtung verbunden ist.

Das erfindungsgemäße Leistungshalbleitermodul weist ein Substrat auf dessen mindestens eine Oberfläche eine dreidimensionale Kontur aufweist. Hierzu ist auf der mindestens einen Oberfläche einer isolierenden Lage des Substrats eine erste in sich strukturierte Metalllage angeordnet, wobei auf dieser ersten Metalllage eine zweite Metalllage mit mindestens einer zweiten Teillage angeordnet ist, die diese dreidimensionale Oberflächenkontur aufweist. Diese dreidimensionale Oberflächenkontur bildet mindestens zwei Ebenen aus, wobei auf diesen Ebenen Kontaktflächen für interne oder externe Verbindungen vorgesehen sind. Hierbei ist es besonders bevorzugt, wenn die jeweilige zweite die ihr zugeordnete erste Teillage zu mindestens 90% überdeckt.

Der Aufbau mit einer isolierenden Lage und einer ersten strukturierten Metalllage ähnelt den bekannten DCB- Substraten, wobei hier allerdings diese erste Metalllage vorzugsweise um den Faktor 10 dünner ausgebildet ist.

Neben dem Substrat weist das erfindungsgemäße Leistungshalbleitermodul übliche Komponenten wie beispielhaft Last- und Hilfsanschlusselemente zur externen elektrischen Verbindung und eine Mehrzahl von Leistungshalbleiterbauelementen auf, wobei mindestens eines dieser Leistungshalbleiterbauelemente auf einer zweiten Teillage der zweiten Metalllage angeordnet ist. Zur schaltungsgerechten internen elektrischen Verbindung weist das Leistungshalbleitermodul vorzugsweise noch eine Verbindungseinrichtung auf, wie sie beispielhaft aus dem Stand der Technik bekannt ist. Diese dient unter anderem dazu mindestens eine Kontaktfläche des Substrats, mit mindestens einer dem Substrat abgewandten Kontaktfläche mindestens eines Leistungshalbleiterbauelements zu verbinden.

Ebenso kann es bevorzugt sein, wenn mindestens eine zweite Teillage der zweiten Metalllage eine zugeordnete erste Teillage der ersten Metalllage in deren Randbereich überragt und in ihrem weiteren Verlauf selbst ein erstes externes Anschlusselement des Leistungshalbleitermoduls ausbildet.

Alternativ oder zusätzlich kann es bevorzugt sein, wenn mindestens eine zweite Teillage der zweiten Metalllage einen Abschnitt aufweist, der die zugeordnete erste Teillage seitlich nicht überragt, der allerdings unter einem Winkel von dieser wegragt und in seinem weiteren Verlauf ein zweites externes Anschlusselement des Leistungshalbleitermoduls ausbildet.

Für bestimmte Anwendungen kann es bevorzugt sein, wenn die dreidimensionale Oberflächenkontur des Substrats nicht nur auf einer sondern auf beiden Seiten der isolierenden Lage vorgesehen ist.

Das erfindungsgemäße Verfahren zur Herstellung eines derartigen Leistungshalbleitermoduls ausgebildet gemäß obiger Beschreibung ist **gekennzeichnet durch** folgende wesentliche Schritte:
- Bereitstellen eines Grundsubstrats mit der isolierenden Lage und hierauf angeordneter erster in sich strukturierter Metalllage, wobei diese Strukturierung die ersten Teillagen ausbildet. Diese ersten Teillagen bilden die schaltungstechnische Grundstruktur des Leistungshalbleitermoduls.
- Ausbilden der mindestens einen zweiten Metalllage mit dreidimensionaler Oberflächenkontur, wobei dies vorzugsweise durch Stanz- Biegetechnik oder durch Falten eines Metallkörpers konstanter Dicke erfolgt. Aus diesem Metallkörper beispielhafte einer Metallfolie mit einer Dicke in der Größenordnung von 100µm wird somit die dreidimensionale Struktur des Substrats gebildet. Einzelne zweite Teillagen, die die zweite Metalllage bilden, werden vorzugsweise gesondert gefertigt. Es kann allerdings auch bevorzugt sein mehrere zweite Teillagen aus einem gemeinsamen Werkstück zu fertigen und erst nach deren Anordnung auf dem Grundsubstrat zu vereinzeln, indem beispielhaft dann noch bestehende Verbindungen entfernt werden.
- Verbinden der mindestens einen zweiten Teillage der zweiten Metalllage mit der zugeordneten ersten Teillage der ersten Metalllage, vorzugsweise mittels eines Drucksinterverfahrens.
- Anordnen mindesten eines Leistungshalbleiterbauelements auf einer ersten Ebene der dreidimensionalen zweiten Teillage.
- In manchen bevorzugten Fällen kann sich nun noch ein weiterer Verformungsschritt eines Abschnitt einer zweiten Teillage anschließen, wobei dieser Abschnitt hierbei teilweise auf einem Leistungshalbleiterbauelement zu liegen kommt und somit anstelle einer zusätzlichen Verbindungseinrichtung die schaltungsgerechte interne Verbindung, vorzugsweise Lastverbindung, herstellt.

Vorteilhaft an dem genannten Herstellungsverfahren und dem zugeordnete Leistungshalbleitermodul ist, dass durch die Ausgestaltung der zweiten Metalllage mit der dreidimensionalen Oberflächenstruktur sowohl eine Verbindungseinrichtung einfach anordenbar ist wie auch zusätzlich oder alternativ das Substrat, genauer zweite Teillagen, selbst als Verbindungs- oder Anschusselement dienen können.

Besonders bevorzugte Weiterbildungen der Erfindung sind in der jeweiligen Beschreibung der Ausführungsbeispiele genannt. Die erfinderische Lösung wird zudem anhand der Ausführungsbeispiele und der Fig. 1 bis 6 weiter erläutert.

Fig. 1 zeigt verschiedene Stadien einer ersten Ausbildung einer zweiten Teillage eines erfindungsgemäßen Leistungshalbleitermoduls.

Fig. 2 zeigt verschiedene Stadien einer zweiten Ausbildung einer zweiten Teillage eines erfindungsgemäßen Leistungshalbleitermoduls in zwei Ansichten.

Fig. 3 zeigt verschiedene Stadien einer dritten Ausbildung einer zweiten Teillage eines erfindungsgemäßen Leistungshalbleitermoduls.

Fig. 4 zeigt eine Ausgestaltung eines Substrats eines erfindungsgemäßen Leistungshalbleitermoduls.

Fig. 5 zeigt wesentliche Komponenten eines erfindungsgemäßen Leistungshalbleitermoduls in einer Explosionsdarstellung.

Fig. 6 zeigt wesentlich Komponenten eines weiteren erfindungsgemäßen Leistungshalbleitermoduls.

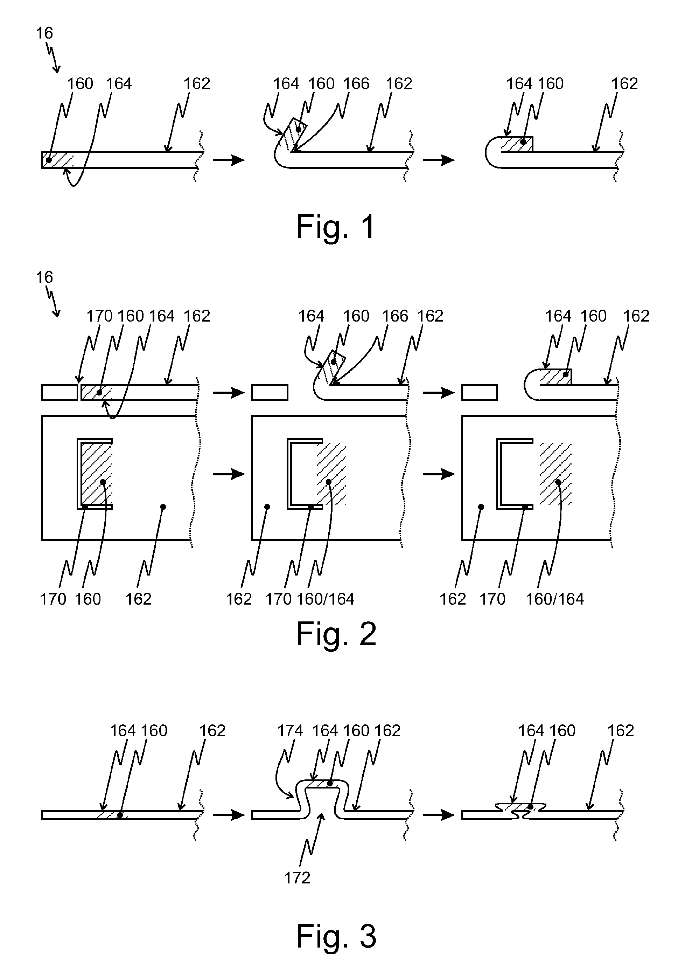

Fig. 1 zeigt verschiedene Stadien einer ersten Ausbildung einer zweiten Teillage (16) eines erfindungsgemäßen Leistungshalbleitermoduls. Dargestellt ist ein Metallkörper in Form einer Metallfolie mit einer Dicke in der Größenordnung von 100µm, besonders bevorzugt ist hier eine Kupferfolie mit einer Dicke zwischen 80µm und 500µm. Der schraffierte Bereich (160) bildet nach dem Herstellungsprozess eine dreidimensionale Kontur der Oberfläche mit einer ersten (162) und einer zweiten Ebene (164) aus. Der schraffierte Bereich (160) wird hierzu um eine Biegekante (166) abgekantet, bis er auf der ersten Ebene (162) zu liegen kommt. Für manche Anwendungen kann es bevorzugt sein, die Abkantung um einen Winkel kleiner als 180° auszuführen, beispielhaft zur Ausbildung von Lastanschlusselementen.

Fig. 2 zeigt verschiedene Stadien einer zweiten Ausbildung einer zweiten Teillage (16) eines erfindungsgemäßen Leistungshalbleitermoduls in zwei Ansichten. Den Ausgangspunkt bildet hier ein mit der Beschreibung gemäß Fig. 1 vergleichbarer Metallkörper. Hiervon wird mindestens ein Abschnitt durch eine U-förmige Stanzung (170) freigestellt und in einem weiteren Schritt wird dieser Bereich entlang einer Biegekante (166) derart abgekantet, dass er wiederum auf der Fläche der ersten Ebene (162) zu liegen kommt, wodurch wiederum die dreidimensionale Oberflächenkontur der zweiten Teillage (16) entsteht.

Fig. 3 zeigt verschiedene Stadien einer dritten Ausbildung einer zweiten Teillage (16) eines erfindungsgemäßen Leistungshalbleitermoduls. Hierbei wird ein Metallkörper in einem Bereich mittels geeigneter Verformung (172) aufgeworfen, wodurch mindestens ein Doppelfalz (174) entsteht. Dieser Doppelfalz (174) wird in einem nächsten, unmittelbar anschließenden Schritt auf die Oberfläche der ersten Ebene (162) gedrückt, wodurch eine zweite Ebene (164) die dreidimensionale Oberflächenkontur entsteht.

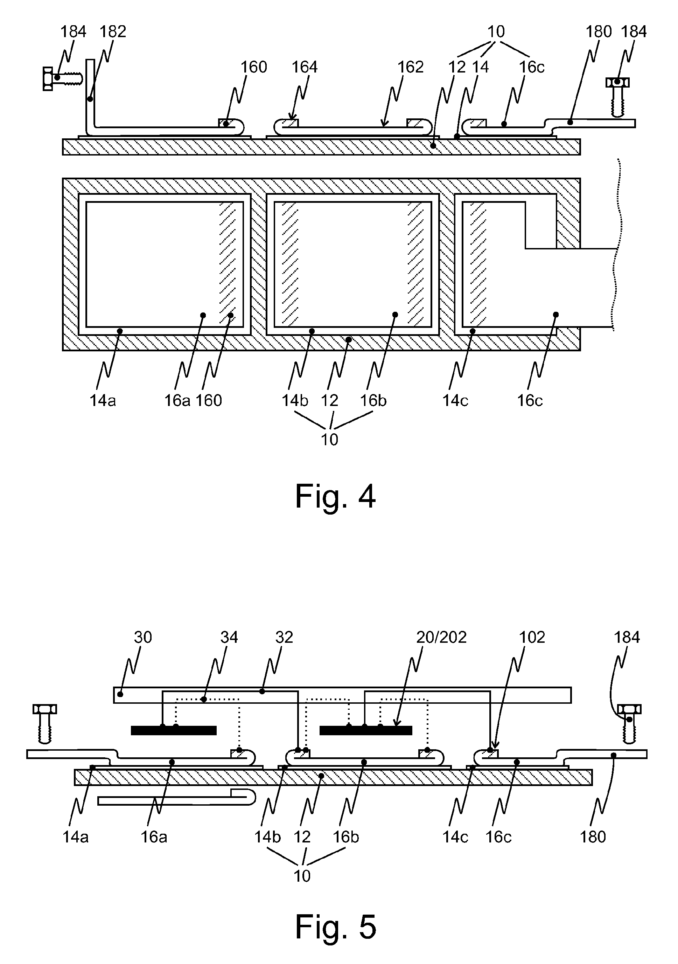

Fig. 4 zeigt eine Ausgestaltung eines Substrats (10) eines erfindungsgemäßen Leistungshalbleitermoduls. Dargestellt ist hier in zwei Ansichten ein Substrat (10), wie es beispielhaft, allerdings ohne Beschränkung hierauf, einen Isolierstoffgrundkörper in Form einer Keramik als isolierende Lage (12) aufweist. Dieser hat eine bevorzugt Dicke in der Größenordndung von einem Millimeter, typisch von 500µm. Hierauf ist eine erste Metalllage angeordnet und zu ersten Teillagen (14 a/b/c) strukturiert. Diese weisen eine bevorzugte Dicke in der Größenordung von 10µm auf. Als Werkstoff hierfür eignet sich besonders ein Edelmetall mit verschiedenen gering dosierten Beimengungen weiterer Metalle oder Metalloxide oder aber Kupfer mit einer Edelmetalloberfläche.

Die zweite Metalllage wird aus einer Mehrzahl von zweiten Teillagen (16 a/b/c) gebildet, wie sie beispielhaft anhand der Figuren 1 bis 3 prinzipiell beschrieben, hergestellt wurden. Die links dargestellte erste Teillage (14a) der ersten Metalllage wird von der zugeordneten zweiten Teillage (16a) zu 90% überdeckt um ausreichend Platz für, auf der ersten Ebene (162) der zweiten Teillage (20) anzuordnende, Bauelemente zur Verfügung zu haben. Eine vollständige Überdeckung kann aus diesem Gesichtspunkt ebenfalls vorteilhaft sein. Links ist ein zweites Lastanschlusselement dargestellt, das derart herstellt wurde, indem analog beispielhaft gemäß Fig.1 ein Abschnitt der zweiten Teillage nur soweit abgekantet wurden, dass er unter einem Winkel, hier beispielhaft 90° von dieser Teillage wegragt. In seinem weiteren Verlauf bildet dieser Abschnitt ein zweites externes Lastanschlusselement (182) des Leistungshalbleitermoduls aus, das mittels eines Verbindungsmittels (184) dem externen Anschluss dient.

Die mittig dargestellte erste Teillage (14b) wird ebenfalls von einer zweiten Teillage (16b) überdeckt, die allerdings an zwei Seiten eine gleichartige dreidimensionale Oberflächenkontur ausbildet.

Die rechts dargestellte erste Teillage (14c) wird zum Rand des Substrats (10) hin von der zugeordneten zweiten Teillage (16c) überragt. Dieser Bereich dient in seinem weiteren Verlauf als erstes externes Lastanschlusselement (180) des Leistungshalbleitermoduls.

Die jeweiligen zweiten Teillagen (16 a/b/c) sind hier als Kupferfolien mit einer Dicke von 350µm ausgebildet und an ihrer der jeweiligen ersten Teillage (14 a/b/c) zugewandten Oberfläche mit einer Edelmetalloberfläche versehen, um mit der jeweiligen ersten Teillage (14 a/b/c) mittels einer Drucksinterverbindung verbunden werden zu können.

Fig. 5 zeigt wesentliche Komponenten eines erfindungsgemäßen Leistungshalbleitermoduls in einer Explosionsdarstellung, wobei das Substrat (10) demjenigen gemäß Fig. 4 weitgehend entspricht. Auf der jeweils ersten Ebene (162) der zweiten Teillagen (16 a/b) sind somit elektrisch voneinander isoliert jeweils ein Leistungshalbleiterbauelement (20) angeordnet.

Eine Verbindungseinrichtung (30), wie sie beispielhaft aus dem Stand der Technik bekannt ist, verbindet (32) eine auf der dem Substrat (10) abgewandten Seite angeordnet Kontaktfläche (202) des linken Leistungshalbleiterbauelements (20) mit einer Kontaktfläche (202) des Substrats (10), angeordnet auf der zweiten Ebene (164) der mittleren zweiten Teillage (16b). Hierzu ist die Verbindungseinrichtung (30) selbstverständlich derart ausgebildet, dass eine leitende Verbindung (34) zwischen der Kontaktfläche (202) des Leistungshalbleiterbauelements (20) und der Kontaktfläche (102) der zweiten Ebene (164) der linken zweiten Teillage (16a) nicht erfolgt. Es werden also alle nicht schaltungsgerechten Verbindungen (34) auch nicht ausgebildet.

In ebensolcher Weise verbindet (32) die Verbindungseinrichtung (30) die Kontaktfläche (202) des Leistungshalbleiterbauelements (20) auf der ersten Ebene (162) der mittleren zweiten Teillage (16b) mit der rechten zweiten Teillage (16c). Aus dem Stand der Technik derartiger Verbindungseinrichtungen (30) ist auch bekannt mehrere Kontaktflächen, beispielhaft Emitter- und Gatekontaktflächen eines Leistungstransistors, (20) zu kontaktieren und somit schaltungsgerecht zu verbinden.

Ein wesentlicher Vorteil des erfindungsgemäßen Leistungshalbleitermoduls ist hier, dass alle zu verbindenden Kontaktflächen (102, 202) geometrisch auf zumindest annährend gleichem Niveau liegen und somit die Verbindungseinrichtung (30) keine wesentlichen Höhenunterschiede überbrücken muss.

Die externen Lastanschlusselemente (180) werden ebenfalls mittels der zweiten Teillagen (16 a/c) ausgebildet, indem diese die zugeordneten ersten Teillagen (14 a/c) sowie hier auch die isolierende Lage (12) des Substrats (10) seitlich überragen und in ihrem weiteren Verlauf mittels geeigneter Verbindungsmittel (184), beispielhaft Schraubverbindungen erste externe Lastanschlusselemente (180) auszubilden.

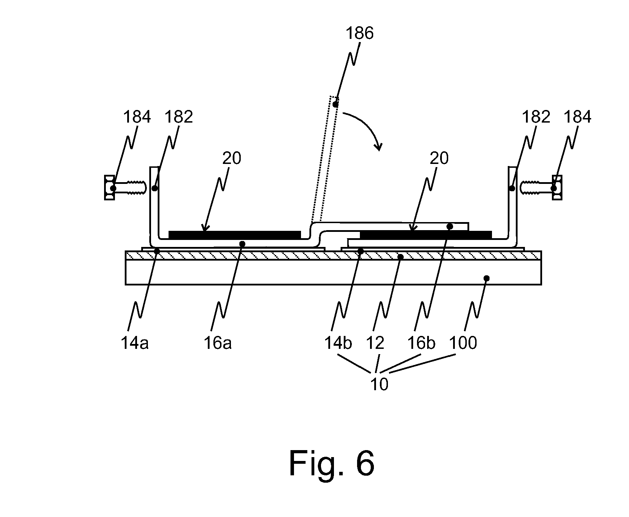

Fig. 6 zeigt wesentlich Komponenten eines weiteren erfindungsgemäßen Leistungshalbleitermoduls. Dargestellt ist hier eine isolierende Lage (12) eines Substrats (10) angeordnet auf einem Metallkörper (100) als Substratbasis. Auf der diesem Metallkörper (100) gegenüberliegenden Seite der isolierenden Lage (12) sind die ersten (14 a/b) und zweiten (16 a/b) Teillagen angeordnet.

Die linke zweite Teillage (16a) weist hierbei wiederum einen Abschnitt auf, der unter einem Winkel von dieser wegragt und ein zweites Lastanschlusselement (182) ausbildet. Weiterhin weist diese linke zweite Teillage (16a) einen weiteren Abschnitt (186) auf, der die zugeordnete erste Teillage (14a) überragt und während des Herstellungsverfahrens zeitlich begrenzt ebenso wie das Lastanschlusselement (182) unter einem Winkel wegragt.

Nach Anordnung eines Leistungshalbleiterbauelements (20) auf der rechten zweiten Teillage (16b), ebenfalls mit einem zweiten Lastanschlusselement (182) wird in einem späteren Schritt des Herstellungsverfahrens der weitere Abschnitt (186) der linken zweiten Teillage (16a) nochmals verformt. Durch diese weitere Verformung kommt er auf der dem Substrat (10) abgewandter Oberfläche des Leistungshalbleiterbauelements (20) der rechten zweiten Teillage (16b) zu liegen und bildet somit eine modulinterne Lastverbindung aus. Durch diese Ausgestaltung lassen sich beispielhaft antiparallele Verschaltungen von zwei Thyristoren ohne zusätzlich modulinterne Verbindungseinrichtungen ausbilden.

## Patentansprüche

1. Leistungshalbleitermodul mit einem Substrat (10), Anschlusselementen (180, 182) zur externen elektrischen Verbindung und einer Mehrzahl von Leistungshalbleiterbauelementen (20), wobei
das Substrat (10) eine elektrisch isolierende Lage (12) aufweist, auf der eine erste Metalllage angeordnet ist, die in sich strukturiert ist und somit erste Teillagen (14 a/b/c) ausbildet und wobei auf dieser ersten Metalllage eine zweite Metalllage mit mindestens einer zweiten Teillage (16 a/b/c) angeordnet ist, die eine dreidimensionale Oberflächenkontur aufweist.

2. Leistungshalbleitermodul nach Anspruch 1,
wobei mindestens eine zweite Teillage (16 a/b/c) der zweiten Metalllage die zugeordnete erste Teillage (14 a/b/c) zu mindestens 90% überdeckt.

3. Leistungshalbleitermodul nach Anspruch 1,
wobei mindestens eine zweite Teillage (16 a/b/c) der zweiten Metalllage die zugeordnete erste Teillage (14 a/b/c) in deren Randbereich überragt und in ihrem weiteren Verlauf ein erstes externes Lastanschlusselement (180) des Leistungshalbleitermoduls ausbildet.

4. Leistungshalbleitermodul nach Anspruch 1,
wobei mindestens eine zweite Teillage (16 a/b/c) der zweiten Metalllage einen Abschnitt aufweist, der unter einem Winkel von dieser wegragt und in seinem weiteren Verlauf ein zweites externes Lastanschlusselement (182) des Leistungshalbleitermoduls ausbildet.

5. Verfahren zur Herstellung eines Leistungshalbleitermoduls ausgebildet gemäß einem der vorhergehenden Ansprüche, **gekennzeichnet durch** folgende wesentliche Schritte:
• Bereitstellen eines Grundsubstrats mit einer isolierenden Lage (12) und einer in sich strukturierten und somit erste Teillagen (14 a/b/c) ausbildenden ersten Metalllage;
• Ausbilden der mindestens einen zweiten Teillage (16 a/b/c) der zweiten Metalllage mit einer dreidimensionalen Oberflächenstruktur;
• Verbinden der mindestens einen zweiten Teillage (16 a/b/c) der zweiten Metalllage mit der zugeordneten ersten Teillage (14 a/b/c);
• Anordnen mindestens eines Leistungshalbleiterbauelements (20) auf einer zweiten Teillage;

6. Verfahren nach Anspruch 5,
wobei die dreidimensionale Oberflächenstruktur der zweiten Teillage (16 a/b/c) durch Stanz- Biegetechnik aus einem Metallkörper konstanter Dicke ausgebildet wird.

7. Verfahren nach Anspruch 5,
wobei die dreidimensionale Oberflächenstruktur der zweiten Teillage (16 a/b/c) durch Falten eines Metallkörpers konstanter Dicke ausgebildet wird.

8. Verfahren nach Anspruch 5,
wobei die Verbindung zwischen der jeweiligen ersten (14 a/b/c) und zweiten (16 a/b/c) Teillagen mittels eines Drucksinterverfahrens ausgebildet wird.

9. Verfahren nach Anspruch 5,
wobei nach Anordnen des mindestens einen Leistungshalbleiterbauelements (20) ein Abschnitt (186) einer zweiten Teillage (16a) nochmals verformt wird und hierbei teilweise auf dem Leistungshalbleiterbauelement (20) zu liegen kommt.
